# EUROPEAN PATENT SPECIFICATION

(11) **EP 4 261 653 B1**
(45) Date of publication and mention of the grant of the patent: **29.10.2025**
(21) Application number: 21923455.6
(22) Date of filing: 27.12.2021
(51) Int. Cl.: G06F 1/16, H04M 1/02, H04M 1/18

(54) **ELECTRONIC DEVICE COMPRISING BREAKAGE PREVENTION STRUCTURE**
ELEKTRONISCHE VORRICHTUNG MIT BRUCHVERHINDERUNGSSTRUKTUR
DISPOSITIF ÉLECTRONIQUE COMPRENANT UNE STRUCTURE ANTI-CASSE

(30) Priority: 26.01.2021 KR 20210011067
(43) Date of publication of application: 18.10.2023
(73) Proprietor: Samsung Electronics Co., Ltd., Suwon-si, Gyeonggi-do 16677 (KR)
(72) Inventor: KIM, Dooryong, Suwon-si, Gyeonggi-do 16677 (KR); BAEK, Inyoul, Suwon-si, Gyeonggi-do 16677 (KR)
(74) Representative: HGF
(86) International application number: PCT/KR2021/019921
(87) International publication number: WO 2022/164049

(56) References cited:
- EP-A1- 3 734 947
- EP-A1- 3 745 689
- KR-A- 20200 047 253
- KR-A- 20200 101 238
- KR-A- 20200 127 741
- KR-A- 20200 137 902
- US-A1- 2019 018 458

## Description

### [Technical Field]

Various embodiments of the disclosure relate to an electronic device including a breakage prevention structure.

### [Background Art]

As the functional gap between manufacturers is significantly reduced, electronic devices are becoming slimmer to meet consumer's purchasing needs. Also, electronic devices are being developed by increasing rigidity, enhancing design aspects, and differentiating their functions. As part of this trend, electronic devices may require a robust structure that can withstand impact transferred from the outside.

EP 3734947 A1 discusses an electronic device which includes a hinge housing, a first housing connected to one side of the hinge housing, and a second housing connected to an opposite side of the hinge housing. EP 3745689 A1 discusses an electronic device which includes a hinge structure corresponding to a folding region of the electronic device.

### [Disclosure of Invention]

### [Technical Problem]

Electronic devices may include a foldable electronic device, which includes a first housing, a second housing foldably connected to the first housing through a hinge device, and a flexible display disposed to be supported by the first housing and the second housing. The first housing and the second housing may be structurally coupled with a hinge module included in the hinge device, and may be operated while being supported by the hinge module in a folded state and/or an unfolded state. For example, the hinge module is at least partially fixed to the hinge housing including an accommodation portion, and is connected to portions of the first housing and the second housing through at least one rotator included in the hinge module, so that it can induce folding and unfolding operations. In this case, for smooth folding and unfolding operations, the rotator may be disposed to have a flow gap spaced apart by a pre-specified distance in a direction of the folding axis.

However, when the foldable electronic device is exposed to an external impact such as a drop, in particular, when only one of the two housings receives an impact in the direction of the folding axis, the other housing may be displaced, through inertia and/or shearing stress, in the opposite direction at least by the flow gap described above, which may cause breakage and/or malfunction of the flexible display supported by the two housings.

Various embodiments may provide an electronic device including a breakage prevention structure.

According to various embodiments, it is possible to provide an electronic device having a robust structure by including a breakage prevention structure with only a relatively simple structural change.

According to various embodiments, it is possible to provide an electronic device that includes a breakage prevention structure constituted to support smooth folding and/or unfolding operations.

### [Solution to Problem]

The invention is set out in the appended set of claims.

### [Advantageous Effects of Invention]

The electronic device according to an exemplary embodiment of the disclosure includes a breakage prevention structure for preventing distortion due to shearing stress generated in the direction of the folding axis between the two housings in an event of a fall to thereby prevent malfunction and breakage of the display and improve the reliability of the electronic device.

In addition, various effects identified directly or indirectly through this document can be provided.

### [Brief Description of Drawings]

In connection with the description of the drawings, the same or similar reference symbols may be used for the same or similar elements.
FIG. 1 is a view illustrating an electronic device in an unfolded state according to various embodiments of the disclosure.
FIG. 2 is a view illustrating the electronic device of FIG. 1 in a folded state according to various embodiments of the disclosure.
FIG. 3 is an exploded perspective view of an electronic device according to various embodiments of the disclosure.
FIG. 4A is an exploded perspective view of an electronic device according to various embodiments of the disclosure.
FIG. 4B is a perspective view of an electronic device in a folded state according to various embodiments of the disclosure.
FIG. 5 is a schematic view showing arrangement of a hinge device in the electronic device according to various embodiments of the disclosure.
FIG. 6A is an enlarged view of a portion indicated by indicia 6a in FIG. 5 according to various embodiments of the disclosure.
FIG. 6B is a partial cross-sectional perspective view of a hinge housing and a rotator viewed along line 6b-6b in FIG. 6A according to various embodiments of the disclosure.
FIG. 7A is a partial configuration view showing arrangement of the hinge housing and the rotator in the folded state according to various embodiments of the disclosure.
FIG. 7B is a cross-sectional view schematically illustrating a coupling structure between the hinge housing and the rotator viewed along line 7b-7b in FIG. 7A according to various embodiments of the disclosure.
FIG. 7C is a cross-sectional view schematically showing a coupling structure between the hinge housing and the rotator according to various embodiments of the disclosure.
FIG. 8 is a view showing an operational trajectory of the rotator with respect to the hinge housing during a transition from the unfolded state to the folded state according to various embodiments of the disclosure.
FIG. 9A and FIG. 9B are schematic views illustrating the arrangement structure of the hinge housing and the rotator, respectively, in the unfolded state and the folded state of the electronic device according to various embodiments of the disclosure.
FIG. 10 is an enlarged view of a portion indicated by indicia 10 in FIG. 5 according to various embodiments of the disclosure.
FIG. 11 is a partial perspective view of the electronic device including a breakage prevention structure disposed between the hinge housing and the two housings at a portion indicated by indicia 11 in FIG. 4B according to various embodiments of the disclosure.

### [Mode for the Invention]

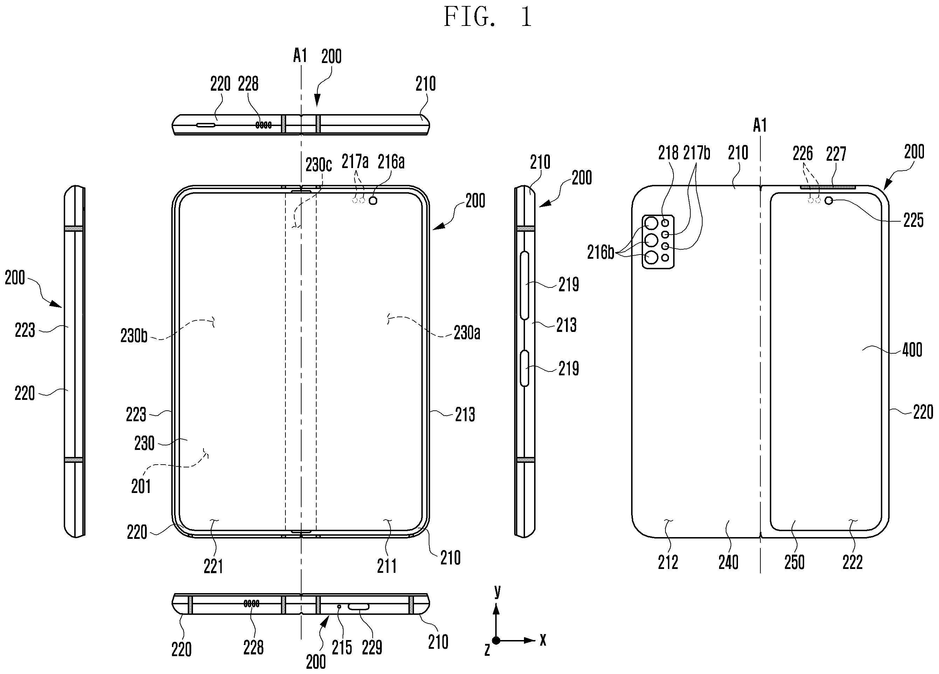

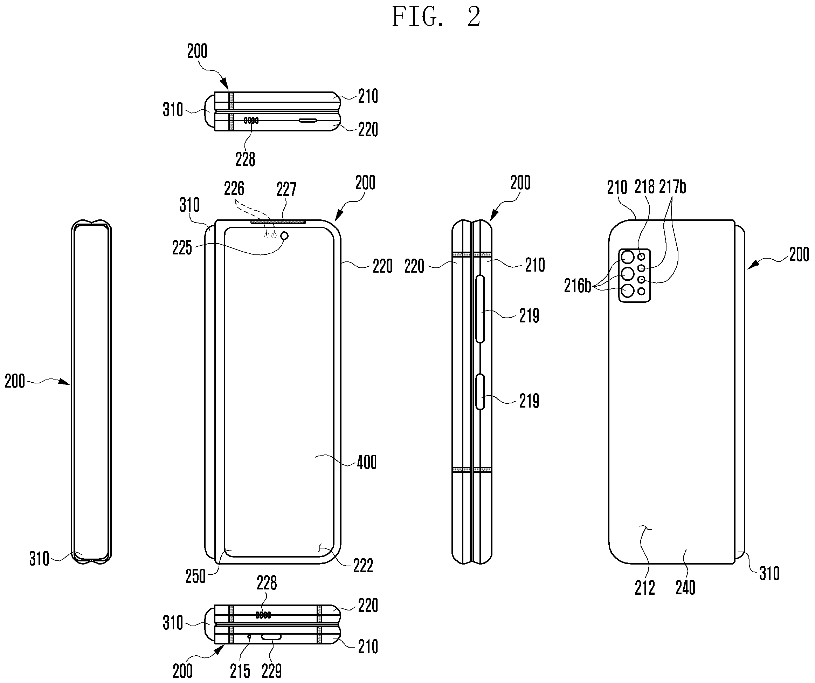

FIG. 1 is a diagram illustrating an unfolded state of an electronic device 200 according to various embodiments of the disclosure. FIG. 2 is a diagram illustrating a folded state of the electronic device 200 of FIG. 1 according to various embodiments of the disclosure.

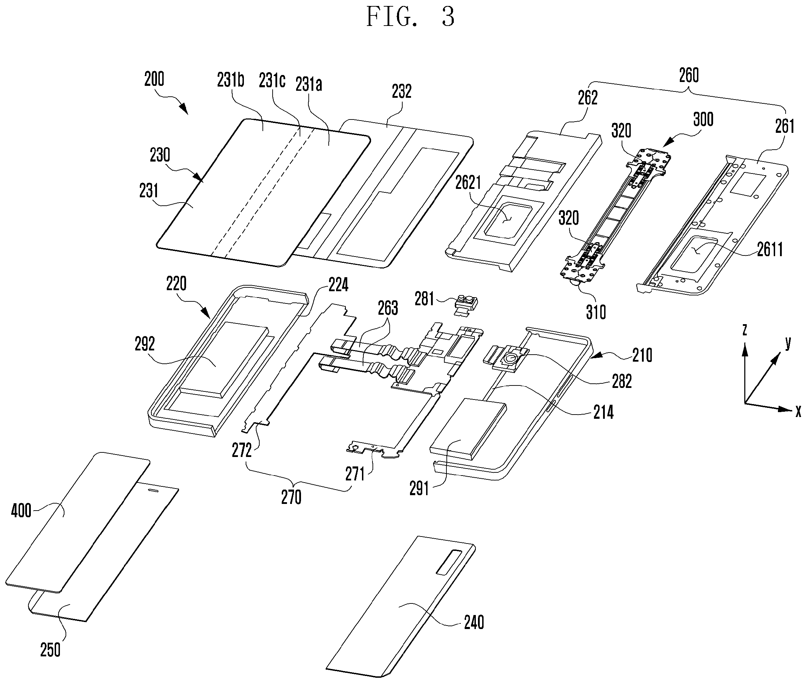

Referring to FIGS. 1 and 2, the electronic device 200 may include a pair of housings 210 and 220 (e.g., foldable housing) rotatably coupled based on a folding axis A1 through a hinge device (e.g., a hinge device 300 of FIG. 3) to be foldable with respect to each other, a first display 230 (e.g., flexible display, foldable display, or main display) disposed through the pair of housings 210 and 220, and/or a second display 400 (e.g., sub-display) disposed through the second housing 220. According to certain embodiments, at least a portion (e.g., hinge device 300 of FIG. 3) of the hinge device (e.g., the hinge device 300 of FIG. 3) may be disposed to not be visible from the outside through the first housing 210 and the second housing 220 and disposed to not be visible from the outside through a hinge housing 310 covering a foldable portion in an unfolded state. In this document, a surface in which the first display 230 is disposed may be defined as a front surface of the electronic device 200, and an opposite surface of the front surface may be defined as a rear surface of the electronic device 200. Further, a surface enclosing a space between the front surface and the rear surface may be defined as a side surface of the electronic device 200.

According to various embodiments, the pair of housings 210 and 220 may include a first housing 210 and second housing 220 disposed to be foldable with respect to each other through the hinge device (e.g., the hinge device 300 of FIG. 3). According to certain embodiments, the pair of housings 210 and 220 are not limited to the shape and coupling illustrated in FIGS. 1 and 2, and may be implemented by a combination and/or coupling of other shapes or parts. According to certain embodiments, the first housing 210 and the second housing 220 may be disposed at both sides based on the folding axis A1, and have an overall symmetrical shape with respect to the folding axis A1. According to some embodiments, the first housing 210 and the second housing 220 may be folded asymmetrically based on the folding axis A1. According to certain embodiments, the first housing 210 and the second housing 220 may have different angles or distances from each other according to whether the electronic device 200 is in an unfolded state, a folded state, or an intermediate state.

According to various embodiments, when the electronic device 200 is in an unfolded state, the first housing 210 may include a first surface 211 connected to the hinge device (e.g., the hinge device 300 of FIG. 3) and disposed to face the front of the electronic device 200, a second surface 212 facing in a direction opposite to that of the first surface 211, and/or a first side member 213 enclosing at least a portion of a first space between the first surface 211 and the second surface 212. According to certain embodiments, when the electronic device 200 is in an unfolded state, the second housing 220 may include a third surface 221 connected to the hinge device (e.g., the hinge device 300 of FIG. 3), and disposed to face the front of the electronic device 200, a fourth surface 222 facing in a direction opposite that of the third surface 221, and/or a second side member 223 enclosing at least a portion of a second space between the third surface 221 and the fourth surface 222. According to certain embodiments, the first surface 211 may face in substantially the same direction as that of the third surface 221 when the electronic device is in an unfolded state and at least partially face the third surface 221 when the electronic device is in a folded state. According to certain embodiments, the electronic device 200 may include a recess 201 formed to receive the first display 230 through structural coupling of the first housing 210 and the second housing 220. According to certain embodiments, the recess 201 may have substantially the same size as that of the first display 230.

According to various embodiments, the hinge housing 310 (e.g., hinge cover) may be disposed between the first housing 210 and the second housing 220 and be disposed to cover a hinge device (e.g.: the hinge device 300 of FIG. 3) disposed in the hinge housing 310. According to certain embodiments, the hinge housing 310 may be covered by a part of the first housing 210 and the second housing 220 or may be exposed to the outside according to an unfolded state, a folded state, or an intermediate state of the electronic device 200. For example, when the electronic device 200 is in an unfolded state, at least a portion of the hinge housing 310 may be covered by the first housing 210 and the second housing 220 to not be substantially exposed. According to certain embodiments, when the electronic device 200 is in a folded state, at least a portion of the hinge housing 310 may be exposed to the outside between the first housing 210 and the second housing 220. According to certain embodiments, when the first housing 210 and the second housing 220 are in an intermediate state folded with a certain angle, the hinge housing 310 may be at least partially exposed to the outside of the electronic device 200 between the first housing 210 and the second housing 220. For example, an area in which the hinge housing 310 is exposed to the outside may be smaller than that in a fully folded state. According to certain embodiments, the hinge housing 310 may include a curved surface.

According to various embodiments, when the electronic device 200 is in an unfolded state (e.g., the state of FIG. 1), the first housing 210 and the second housing 220 form an angle of approximately 180 degrees, and a first area 230a, a folding area 230c, and a second area 230b of the first display 230 may form the same flat surface and be disposed to face in substantially the same direction. In another embodiment, when the electronic device 200 is in an unfolded state, the first housing 210 may rotate at an angle of approximately 360 degrees with respect to the second housing 220 so that the second surface 212 and the fourth surface 222 may be reversely folded to face each other (out-folding method).

According to various embodiments, when the electronic device 200 is in the folded state (e.g., the state of FIG. 3), the first surface 211 of the first housing 210 and the third surface 221 of the second housing 220 may be disposed to face each other. In this case, the first area 230a and the second area 230b of the first display 230 may form a narrow angle (e.g., a range of 0 degree to approximately 10 degree) each other through the folding area 230c and be disposed to face each other. According to certain embodiments, at least a portion of the folding area 230c may be transformed into a curved shape having a predetermined curvature. According to certain embodiments, when the electronic device 200 is in an intermediate state, the first housing 210 and the second housing 220 may be disposed at a certain angle to each other. In this case, the first area 230a and the second area 230b of the first display 230 may form an angle larger than the folded state and smaller than the unfolded state, and a curvature of the folding area 230c may be smaller than that of the folded state and be larger than that of the unfolded state. In some embodiments, the first housing 210 and the second housing 220 may form an angle that may stop at a specified folding angle between the folded state and the unfolded state through the hinge device (e.g., the hinge device 300 of FIG. 3) (free stop function). In some embodiments, the first housing 210 and the second housing 220 may be operated while being pressurized in an unfolding direction or a folding direction based on a specified inflection angle through the hinge device (e.g., the hinge device 300 of FIG. 3).

According to various embodiments, the electronic device 200 may include at least one of at least one display 230 and 400, an input device 215, sound output devices 227 and 228, sensor modules 217a, 217b, and 226, camera modules 216a, 216b, and 225, a key input device 219, an indicator, or a connector port 229 disposed in the first housing 210 and/or the second housing 220. In some embodiments, the electronic device 200 may omit at least one of the components or may additionally include at least one other component.

According to various embodiments, the at least one display 230 and 400 may include a first display 230 (e.g., flexible display) disposed to receive support from the third surface 221 of the second housing 220 through the hinge device (e.g., the hinge device 300 of FIG. 3) from the first surface 211 of the first housing 210, and a second display 400 disposed to be visible at least partially from the outside through the fourth surface 222 in an inner space of the second housing 220. As another example, the second display 400 may be disposed to be visible from the outside through the second surface 212 in an inner space of the first housing 210. According to certain embodiments, the first display 230 may be mainly used in an unfolded state of the electronic device 200, and the second display 400 may be mainly used in a folded state of the electronic device 200. According to certain embodiments, when the electronic device 200 is in an intermediate state, the electronic device 200 may control the first display 230 and/or the second display 400 to be usable based on a folding angle of the first housing 210 and the second housing 220.

According to various embodiments, the first display 230 may be disposed in a receiving space formed by a pair of housings 210 and 220. For example, the first display 230 may be disposed in the recess 201 formed by the pair of housings 210 and 220, and when the electronic device 200 is in an unfolded state, the first display 230 may be disposed to occupy substantially most of the front surface of the electronic device 200. According to certain embodiments, the first display 230 may include a flexible display whose at least a partial area may be transformed into a flat surface or a curved surface. According to certain embodiments, the first display 230 may include a first area 230a facing the first housing 210, a second area 230b facing the second housing 220, and a folding area 230c connecting the first area 230a and the second area 230b and facing the hinge device (e.g., the hinge device 300 of FIG. 3). According to certain embodiments, area division of the first display 230 is an exemplary physical division by a pair of housings 210 and 220 and the hinge device (e.g., the hinge device 300 of FIG. 3), and the first display 230 may be displayed as a substantially seamless single full screen through the pair of housings 210 and 220 and the hinge device (e.g., the hinge device 300 of FIG. 3). According to certain embodiments, the first area 230a and the second area 230b may have an overall symmetrical shape or a partially asymmetrical shape based on the folding area 230c.

According to various embodiments, the electronic device 200 may include a first rear cover 240 disposed at the second surface 212 of the first housing 210 and a second rear cover 250 disposed at the fourth surface 222 of the second housing 220. In some embodiments, at least a portion of the first rear cover 240 may be integrally formed with the first side member 213. In some embodiments, at least a portion of the second rear cover 250 may be integrally formed with the second side member 223. According to certain embodiments, at least one cover of the first rear cover 240 and the second rear cover 250 may be formed with a substantially transparent plate (e.g., a polymer plate or a glass plate including various coating layers) or an opaque plate. According to certain embodiments, the first rear cover 240 may be formed by an opaque plate such as, for example, coated or tinted glass, ceramic, polymer, metal (e.g., aluminum, stainless steel (STS), or magnesium), or a combination of at least two of the above materials. According to certain embodiments, the second rear cover 250 may be formed through a substantially transparent plate such as glass or polymer, for example. Accordingly, the second display 400 may be disposed to be visible from the outside through the second rear cover 250 in an inner space of the second housing 220.

According to various embodiments, the input device 215 may include a microphone. In some embodiments, the input device 215 may include a plurality of microphones disposed to detect a direction of a sound. According to certain embodiments, the sound output devices 227 and 228 may include speakers. According to certain embodiments, the sound output devices 227 and 228 may include a call receiver 227 disposed through the fourth surface 222 of the second housing 220 and an external speaker 228 disposed through at least a portion of the second side member 223 of the second housing 220. In some embodiments, the input device 215, the sound output devices 227 and 228, and the connector 229 may be disposed in spaces of the first housing 210 and/or the second housing 220 and be exposed to an external environment through at least one hole formed in the first housing 210 and/or the second housing 220. In some embodiments, holes formed in the first housing 210 and/or the second housing 220 may be commonly used for the input device 215 and the sound output devices 227 and 228. In some embodiments, the sound output devices 227 and 228 may include a speaker (e.g., piezo speaker) operating while excluding a hole formed in the first housing 210 and/or the second housing 220.

According to various embodiments, the camera modules 216a, 216b, and 225 may include a first camera module 216a disposed at the first surface 211 of the first housing 210, a second camera module 216b disposed at the second surface 212 of the first housing 210, and/or a third camera module 225 disposed at the fourth surface 222 of the second housing 220. According to certain embodiments, the electronic device 200 may include a flash 218 disposed near the second camera module 216b. According to certain embodiments, the flash 218 may include, for example, a light emitting diode or a xenon lamp. According to certain embodiments, the camera modules 216a, 216b, and 225 may include one or a plurality of lenses, an image sensor, and/or an image signal processor. In some embodiments, at least one camera module of the camera modules 216a, 216b, and 225 may include two or more lenses (e.g., wide-angle and telephoto lenses) and image sensors and be disposed together at any one surface of the first housing 210 and/or the second housing 220.

According to various embodiments, the sensor modules 217a, 217b, and 226 may generate an electrical signal or a data value corresponding to an internal operating state of the electronic device 200 or an external environmental state. According to certain embodiments, the sensor modules 217a, 217b, and 226 may include a first sensor module 217a disposed at the first surface 211 of the first housing 210, a second sensor module 217b disposed at the second surface 212 of the first housing 210, and/or a third sensor module 226 disposed at the fourth surface 222 of the second housing 220. In some embodiments, the sensor modules 217a, 217b, and 226 may include at least one of a gesture sensor, a grip sensor, a color sensor, an infrared (IR) sensor, an illuminance sensor, an ultrasonic sensor, an iris recognition sensor, or a distance detection sensor (e.g., time of flight (TOF) sensor or light detection and ranging (LiDAR)).

According to various embodiments, the electronic device 200 may further include a sensor module, for example, at least one of an atmospheric pressure sensor, a magnetic sensor, a biometric sensor, a temperature sensor, a humidity sensor, or a fingerprint recognition sensor. In some embodiments, the fingerprint recognition sensor may be disposed through at least one of the first side member 213 of the first housing 210 and/or the second side member 223 of the second housing 220.

According to various embodiments, the key input device 219 may be disposed to be exposed to the outside through the first side member 213 of the first housing 210. In some embodiments, the key input device 219 may be disposed to be exposed to the outside through the second side member 223 of the second housing 220. In some embodiments, the electronic device 200 may not include some or all of the key input devices 219, and the non-included key input devices 219 may be implemented into other forms such as soft keys on at least one display 230 and 400. As another embodiment, the key input device 219 may be implemented using a pressure sensor included in at least one display 230 and 400.

According to various embodiments, the connector port 229 may include a connector (e.g., USB connector or interface connector port module (IF module)) for transmitting and receiving power and/or data to and from an external electronic device. In some embodiments, the connector port 229 may further include a separate connector port (e.g., ear jack hole) for performing together a function for transmitting and receiving an audio signal to and from an external electronic device or for performing a function of transmitting and receiving an audio signal.

According to various embodiments, at least one camera module 216a and 225 of the camera modules 216a, 216b, and 225, at least one sensor module 217a and 226 of the sensor modules 217a, 217b, and 226, and/or the indicator may be disposed to be exposed through at least one display 230 and 400. For example, the at least one camera module 216a and 225, the at least one sensor module 217a and 226, and/or the indicator may be disposed under a display area of the displays 230 and 400 in an interior space of the at least one housing 210 and 220 and be disposed to contact an external environment through an opening or transparent area perforated to a cover member (e.g., a window layer of the first display 230 and/or the second rear cover 250). According to certain embodiments, an area in which the displays 230 and 400 and the at least one camera module 216a and 225 face each other is a part of an area displaying contents and may be formed as a transmission area having predetermined transmittance. According to certain embodiments, the transmission area may be formed to have transmittance in a range from approximately 5% to approximately 20%. Such a transmission area may include an area overlapped with an effective area (e.g., view angle area) of the at least one camera module 216a and 225 through which light for generating an image by an image sensor passes. For example, the transmission area of the displays 230 and 400 may include an area having a lower pixel density than that of a peripheral area thereof. For example, the transmission area may replace the opening. For example, the at least one camera module 216a and 225 may include an under display camera (UDC). In another embodiment, some camera modules or sensor modules 217a and 226 may be disposed to perform functions thereof without being visually exposed through the display. For example, an area facing the camera modules 216a and 225 and/or the sensor modules 217a and 226 disposed under the displays 230 and 400 (e.g., display panel) has an under display camera (UDC) structure; thus, a perforated opening may be unnecessary.

FIG. 3 is an exploded perspective view illustrating an electronic device 200 according to various embodiments of the disclosure.

Referring to FIG. 3, the electronic device 200 may include a first display 230, a second display 400, a hinge device 300, a support member assembly 260, at least one printed circuit board 270, a first housing 210, a second housing 220, a first rear cover 240, and/or a second rear cover 250.

According to various embodiments, the first display 230 may include a display panel 231 (e.g., flexible display panel) and one or more plates 232 or layers in which the display panel 231 is seated. According to certain embodiments, the display panel 231 may include a first panel area 231a corresponding to the first area (e.g., the first area 230a of FIG. 1) of the display 230, a second panel area 231b extended from the first panel area and corresponding to the second area (e.g., the second area 230b of FIG. 1) of the display 230, and a third area 231c connecting the first panel area 231a and the second panel area 231b and corresponding to a folding area (e.g., the folding area 230c of FIG. 1) of the display 230. According to certain embodiments, the one or more plates 232 may include a conductive plate (e.g., Cu sheet or SUS sheet) disposed between the display panel 231 and the support member assembly 260. According to certain embodiments, the one or more plates 232 may be formed to have substantially the same area as that of the first display 230, and an area facing a folding area (e.g., the folding area 230c of FIG. 1) of the first display 230 may be formed to be bendable. According to certain embodiments, the one or more plates 232 may include at least one auxiliary material layer (e.g., graphite member) disposed at a rear surface of the display panel 231. According to certain embodiments, the one or more plates 232 may be formed in a shape corresponding to the display panel 231.

According to various embodiments, the second display 400 may be disposed in a space between the second housing 220 and the second rear cover 250. According to certain embodiments, the second display 400 may be disposed to be visible from the outside through substantially the entire area of the second rear cover 250 in a space between the second housing 220 and the second rear cover 250.

According to various embodiments, the support member assembly 260 may include a first support member 261 (e.g., first support plate) and a second support member 262 (e.g., second support plate). According to certain embodiments, the first support member 261 may be foldably coupled to the second support member 262 through the hinge device 300. According to certain embodiments, the electronic device 200 may include at least one wiring member 263 (e.g., flexible printed circuit board (FPCB)) disposed from at least a portion of the first support member 261 across the hinge device 300 to a portion of the second support member 262. According to certain embodiments, the support member assembly 260 may be disposed between one or more plates 232 and at least one printed circuit board 270. According to certain embodiments, the first support member 261 may be disposed between the first area (e.g., the first area 230a of FIG. 1) of the first display 230 and a first printed circuit board 271. According to certain embodiments, the second support member 262 may be disposed between the second area (e.g., the second area 230b of FIG. 1) of the first display 230 and a second printed circuit board 272. According to certain embodiments, the at least one wiring member 263 and/or at least a portion of the hinge device 300 may be disposed to be supported through at least a portion of the support member assembly 260. According to certain embodiments, the at least one wiring member 263 may be disposed in a direction (e.g., x-axis direction) crossing the first support member 261 and the second support member 262. According to certain embodiments, the at least one wiring member 263 may be disposed in a direction (e.g., the x-axis direction) substantially perpendicular to the folding axis (e.g., the y-axis or the folding axis A1 of FIG. 1) of the folding area 230c.

According to various embodiments, the at least one printed circuit board 270 may include a first printed circuit board 271 disposed to face the first support member 261 or a second printed circuit board 272 disposed to face the second support member 262. According to certain embodiments, the first printed circuit board 271 and the second printed circuit board 272 may be disposed in an inner space formed by the support member assembly 260, the first housing 210, the second housing 220, and the first rear cover 240, and/or the second rear cover 250. According to certain embodiments, the first printed circuit board 271 and the second printed circuit board 272 may include a plurality of electronic components disposed to implement various functions of the electronic device 200. In some embodiments, the first support member 261 is a component of the first housing 210 and may be extended at least partially from the first side member 213 to a first space (e.g., first interior space) in which the first housing 210 is formed. In some embodiments, the second support member 262 is a component of the second housing 220 and may be extended at least partially from the second side member 223 to a second space (e.g., second interior space) in which the second housing 220 is formed.

According to various embodiments, the electronic device 200 may include a first printed circuit board 271 disposed in a first space of the first housing 210, a first battery 291 disposed at a position facing a first swelling hole 2611 of the first support member 261, at least one camera module 282 (e.g., the first camera module 216a and/or the second camera module 216b of FIG. 1), or at least one sensor module 281 (e.g., the first sensor module 217a and/or the second sensor module 217b of FIG. 1). According to certain embodiments, the electronic device 200 may include a second printed circuit board 272 disposed in the second space of the second housing 220 or a second battery 292 disposed in a position facing a second swelling hole 2621 of the second support member 262. According to certain embodiments, the first housing 210 may be integrally formed with the first support member 261. According to certain embodiments, the second housing 220 may be integrally formed with the second support member 262.

According to various embodiments, the first housing 210 may include a first rotation support surface 214, and the second housing 220 may include a second rotation support surface 224 corresponding to the first rotation support surface 214. According to certain embodiments, the first rotation support surface 214 and the second rotation support surface 224 may include curved surfaces corresponding to (naturally connected to) a curved outer surface of the hinge housing 310. According to certain embodiments, when the electronic device 200 is in an unfolded state, the first rotation support surface 214 and the second rotation support surface 224 may cover the hinge housing 310, thereby not exposing the hinge housing 310 from the rear surface of the electronic device 200 or exposing only a portion thereof. According to certain embodiments, when the electronic device 200 is in a folded state, the first rotation support surface 214 and the second rotation support surface 224 may rotate along the curved outer surface of the hinge housing 310 to expose at least a portion of the hinge housing 310 to the rear surface of the electronic device 200.

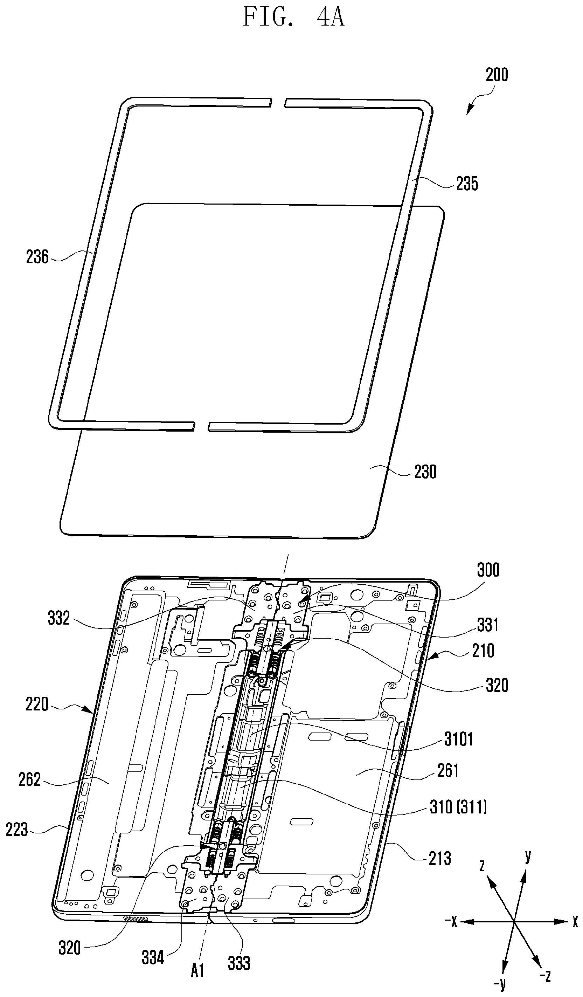

According to various embodiments, the hinge device 300 may include a hinge housing 310 and at least one hinge module 320 disposed in an accommodation portion (e.g., accommodation portion 3101 in FIG. 4A) of the hinge housing 310. According to an embodiment, the hinge module 320 may be fixed to the accommodation portion 3101 of the hinge housing 310, and may be connected to the first support member 261 and the second support member 262 through at least one rotator (e.g., rotators 331, 332, 333, 334 in FIG. 4A).

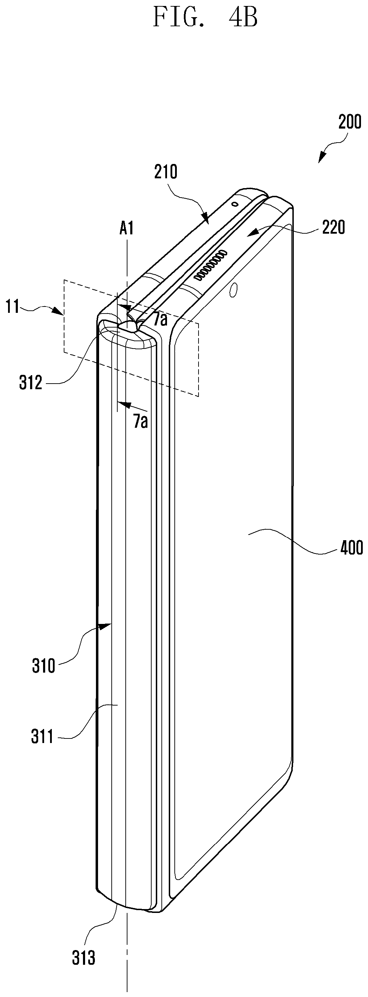

FIG. 4A is an exploded perspective view of an electronic device according to various embodiments of the disclosure. FIG. 4B is a perspective view of an electronic device in a folded state according to various embodiments of the disclosure.

With reference to FIGS. 4A and 4B, the electronic device 200 may include a first housing 210 including a first lateral member 213, a second housing 220 including a second lateral member 223, a hinge device 300 connecting the first housing 210 and the second housing 220 to be foldable with respect to each other, and a display 230 (e.g., first display 230 in FIG. 1) arranged to be supported by the first housing 210, the hinge device 300, and the second housing 220. According to an embodiment, the electronic device 200 may further include a first protection frame 235 coupled to the first housing 210 and a second protection frame 236 coupled to the second housing 220, with the edge of the display 230 interposed therebetween. According to an embodiment, the first housing 210 and the second housing 220 may be operated to be folded or unfolded relative to each other based on the folding axis A1 through the hinge device 300.

According to various embodiments, the hinge device 300 has a length in a direction substantially parallel to the folding axis A1 (e.g., y-axis direction), and may include a hinge housing 310 including an accommodation portion 3101, and at least one hinge module 320 fixed to the accommodation portion 3101 of the hinge housing 310. According to an embodiment, the at least one hinge module 320 may include at least one plate-type rotator 331, 332, 333, 334 that connects the first housing 210 and the second housing 220 to be foldable with respect to each other. According to an embodiment, the hinge housing 310 may include a cover part 311 disposed to have a length along the folding axis A1, a first closed end 312 extended from one end of the cover part 311, and a second closed end 313 extended from the other end of the cover part 311. According to an embodiment, the accommodation portion 3101 may be formed through the cover part 311, the first closed end 312, and the second closed end 313. According to an embodiment, the outer surface of the cover part 311 may be formed in a curved shape, and the cover part 311 may be at least partially exposed to be visible to the outside in the folded state. According to an embodiment, the accommodation portion 3101 may be opened in a direction toward the display 230 and may have a fixing structure and/or a seating structure to which at least one hinge module 320 may be fixed. According to an embodiment, the at least one hinge module 320 may provide a pressing force in a folding direction or unfolding direction with respect to the inflection point during a folding operation and/or unfolding operation of the electronic device, through, although not shown, a hinge shaft, a hinge cam, and a cam member that presses the hinge cam in the longitudinal direction of the hinge shaft through a hinge spring, which are arranged in sequence in a direction substantially parallel to the folding axis A1.

According to various embodiments, the at least one rotator 331, 332, 333, 334 may include a first rotator 331 coupled to the first support member 261 of the first housing 210 near the first closed end 312 being an upper region of the hinge housing 310, a second rotator 332 coupled to the second support member 262 of the second housing 220 near the first closed end 312 being an upper region of the hinge housing, a third rotator 333 coupled to the first support member 261 of the first housing 210 near the second closed end 313 being a lower region of the hinge housing 310, and a fourth rotator 334 coupled to the second support member 262 of the second housing 220 near the second closed end 313 being a lower region of the hinge housing 310. According to an embodiment, the at least one rotator 331, 332, 333, 334 may be coupled to the first support member 261 and the second support member 262 through a fastening member such as a screw. According to an embodiment, the hinge housing 310 may be connected to the first housing 210 and the second housing 220 through at least one hinge module 320. According to an embodiment, to accommodate the display 230, the at least one hinge module 320 including at least one rotator 331, 332, 333, 334 may be coupled to the first support member 261 and the second support member 262 so as to have a substantially flat surface.

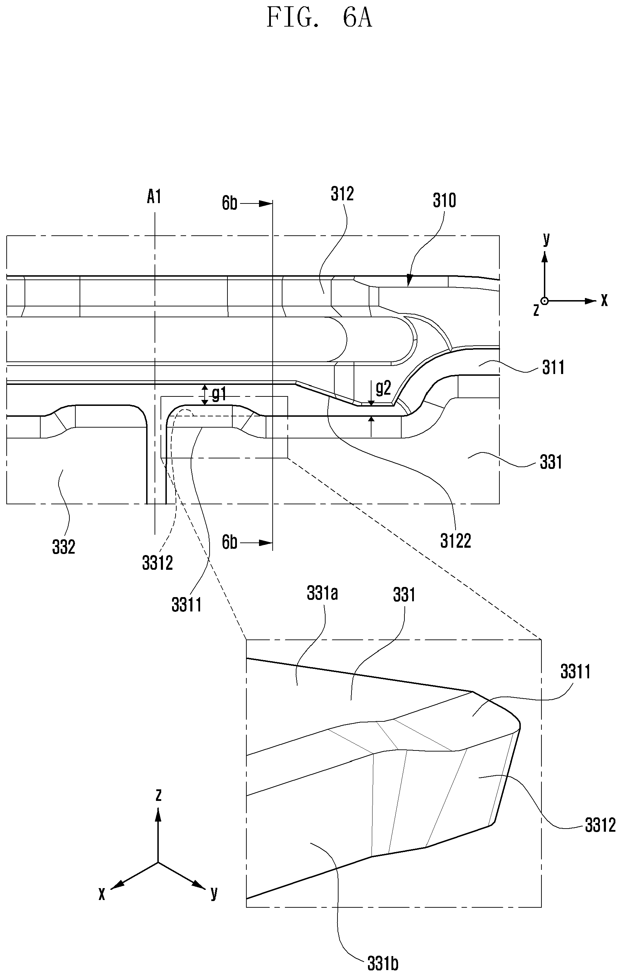

According to various embodiments, the at least one hinge module 320 may be connected to the first housing 210 and the second housing 220 through the at least one rotator 331, 332, 333, 334. In this case, to avoid interference with the hinge housing 310 during folding and/or unfolding, the at least one rotator 331, 332, 333, 334 may be disposed to have a flow gap (e.g., working gap) (e.g., flow gaps g1, g2 in FIG. 6A) in a direction substantially parallel to the folding axis. However, when the electronic device 200 is dropped and one housing is impacted, this flow gap may act as a cause of shearing stress by which the other housing is moved in the opposite direction and the two housings may be misaligned or twisted along the folding axis as much as the flow gap, which may cause damage to the display 230 (e.g., wire disconnection). The electronic device 200 according to exemplary embodiments of the disclosure may include a breakage prevention structure for eliminating such a flow gap when in a folded state. The electronic device 200 according to exemplary embodiments of the disclosure may include a breakage prevention structure for eliminating such a flow gap when in an unfolded state.

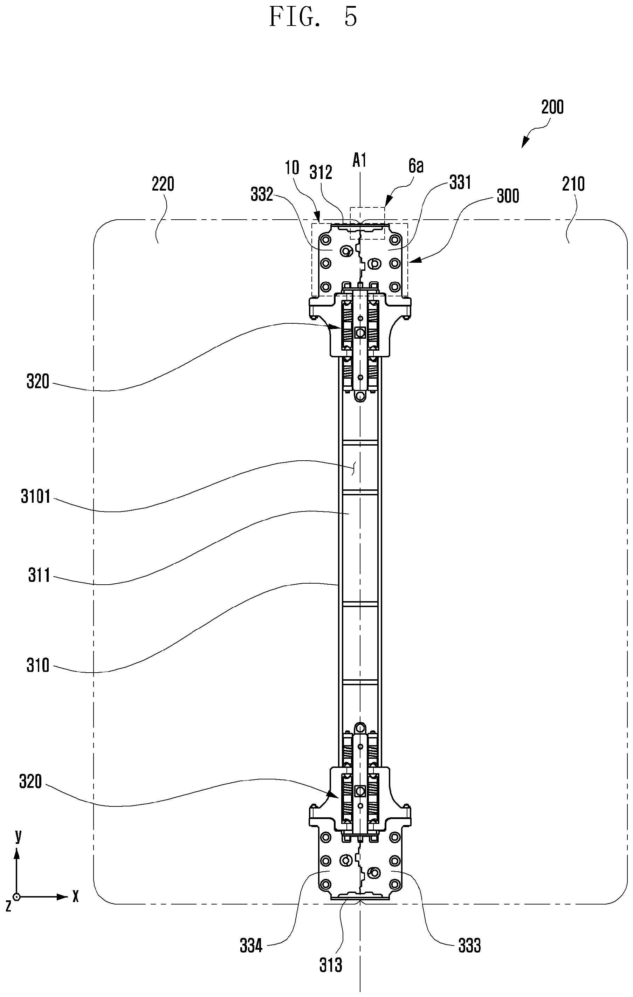

FIG. 5 is a schematic view showing arrangement of the hinge device in the electronic device according to various embodiments of the disclosure.

In the description of the electronic device 200 of FIG. 5, the same reference symbols are assigned to components substantially the same as those of the electronic device 200 of FIGS. 4A and 4B, and a detailed description thereof may be omitted.

FIG. 5 illustrates the arrangement relationship between the hinge device 300, the first housing 210, and the second housing 220 when the electronic device is in an unfolded state. According to an embodiment, the electronic device 200 may include a first housing 210, a second housing 220, and a hinge device 300 that connects the first housing 210 and the second housing 220 to be foldable with respect to each other. According to an embodiment, the hinge device 300 may have a length in a direction substantially parallel to the folding axis A1 (e.g., y-axis direction), may be fixed to the hinge housing 310 including an accommodation portion 3101 and the accommodation portion 3101 of the hinge housing 310, and may include at least one hinge module 320 including rotators 331, 332, 333, 334 fixed to the first housing 210 and the second housing 220. According to an embodiment, the rotators 331, 332, 333, 334 may include a first rotator 331 and a second rotator 332, disposed near the first closed end 312 in the accommodation portion 3101 of the hinge housing 310, and coupled respectively to the first housing 210 and the second housing 220. According to an embodiment, the rotators 331, 332, 333, 334 may include a third rotator 333 and a fourth rotator 334, disposed near the second closed end 313 in the accommodation portion 3101 of the hinge housing 310, and coupled respectively to the first housing 210 and the second housing 220.

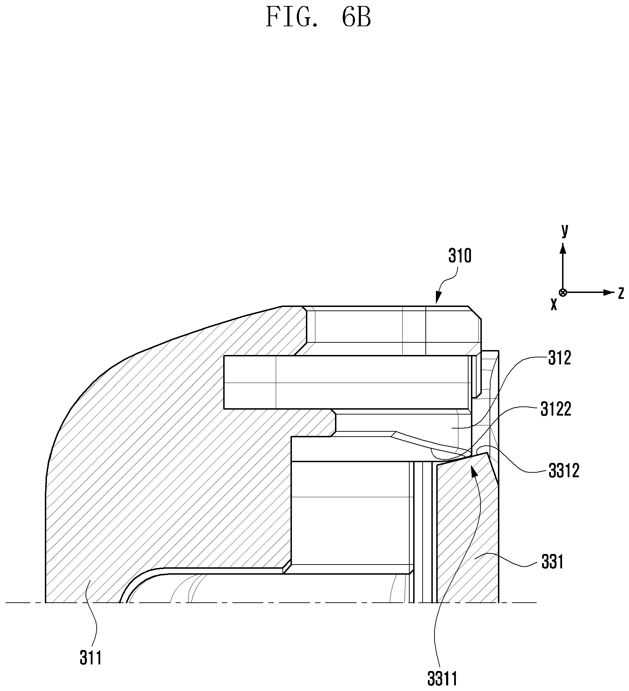

FIG. 6A is an enlarged view of a portion indicated by indicia 6a in FIG. 5 according to various embodiments of the disclosure. FIG. 6B is a partial cross-sectional perspective view of a hinge housing and a rotator viewed along line 6b-6b in FIG. 6A according to various embodiments of the disclosure.

With reference to FIGS. 6A and 6B, when the first housing 210 and the second housing 220 are being folded and/or unfolded with respect to each other, the first rotator 331 and the second rotator 332 may be disposed to have flow gaps g1 and g2 spaced apart from the first closed end 312 by a specified distance in a direction parallel to the folding axis A1 in the accommodation portion 3101 of the hinge housing 310. According to an embodiment, the flow gaps g1 and g2 may be provided to minimize interference caused when the first rotator 331 and the second rotator 332 come into contact with the hinge housing 310 while the first housing 210 and the second housing 220 are being folded and unfolded or in the unfolded state. These flow gaps g1 and g2 may be maintained until the first rotator 331 and the second rotator 332 are changed from the unfolded state to just before the folded state (e.g., until a folding angle of about 5 ° before the completely folded state). Although not shown, the third and fourth rotators 333 and 334 may also have substantially the same structure as to the second closed end 313.

According to an exemplary embodiment of the disclosure, the first rotator 331 may include a protrusion 3311 formed to be extended in the direction of the first closed end 312. According to an embodiment, the protrusion 3311 may include a mounting surface 331a facing the display (e.g., display 230 in FIG. 4A), and a side surface 331b extended from the mounting surface 331a and facing the first closed end 312. According to an embodiment, the first rotator 331 may include a first inclined portion 3312 formed to be inclined at a specified angle θ on the side surface 331b of the protrusion 3311. According to an embodiment, the first closed end 312 may include a second inclined surface 3122 that is formed at a corresponding position so as to come into contact with the first inclined surface 3312 when the electronic device 200 is in the folded state. According to an embodiment, the second inclined surface 3122 may be formed at a position not in contact with the first inclined surface 3312 even when the first rotator 331 is moved in a range from an unfolded state to just before a folded state. In a certain embodiment, the first inclined surface 3312 included in the protrusion 3311 may be formed in a shape that does not come into contact with the second inclined surface 3312 even when the first rotator 331 is moved in a range from an unfolded state to just before a folded state. According to an embodiment, the second inclined surface 3312 may be formed at a position in surface contact with the first inclined surface 3312 when the electronic device 200 reaches the folded state. Hence, the first inclined portion 3312 may be formed to be gradually lowered as it goes in the negative z-axis direction in the unfolded state. According to an embodiment, the second inclined portion 3122 may be formed to be gradually heightened as it goes in the x-axis direction.

Although not shown, the second rotator 332 and the first closed end 312, the third rotator 333 and the second closed end 313, and/or the fourth rotator 334 and the second closed end 313 may also be formed to have a contact structure substantially the same as that of the first inclined portion 3312 formed at the first rotator 331 and the second inclined portion 3122 formed at the first closed end 312.

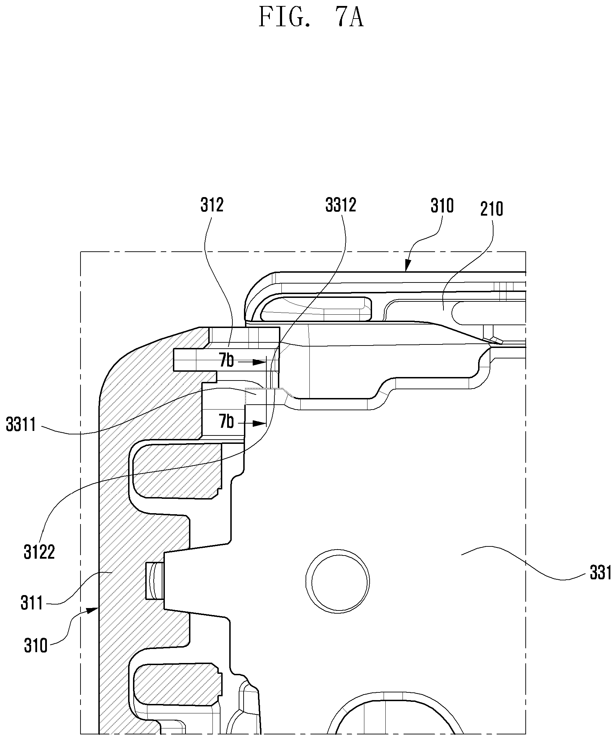

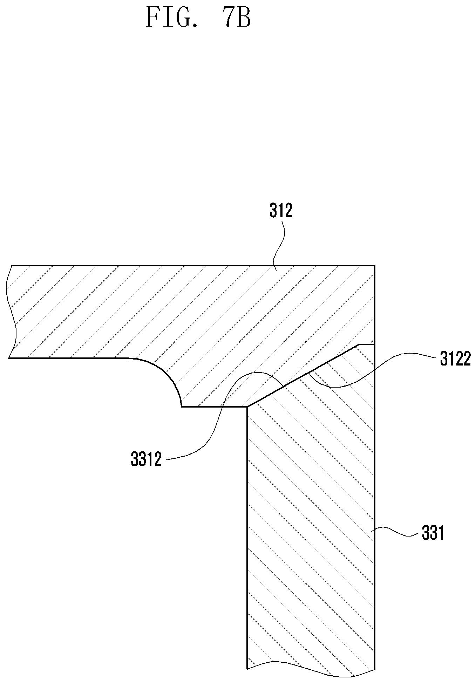

FIG. 7A is a partial configuration view showing arrangement of the hinge housing and the rotator in the folded state according to various embodiments of the disclosure. FIG. 7B is a cross-sectional view schematically illustrating a coupling structure between the hinge housing and the rotator viewed along line 7b-7b in FIG. 7A according to various embodiments of the disclosure.

FIG. 7A is a partial cross-sectional view of the electronic device viewed along line 7a-7a in FIG. 4B.

With reference to FIGS. 7A and 7B, when the electronic device 200 is in the folded state, the first inclined portion 3312 of the first rotator 331 may come into contact with the second inclined portion 3122 of the first closed end 312. According to an embodiment, the first inclined portion 3312 and the second inclined portion 3122 may contact each other at least partially in the form of a surface contact. Although not shown, the second rotator 332 and the first closed end 312, the third rotator 333 and the second closed end 313, and/or the fourth rotator 334 and the second closed end 313 may come at least partially into surface contact with each other in substantially the same manner as the first inclined portion 3312 and the second inclined portion 3122 formed respectively at the first rotator 331 and the first closed end 312. In this case, in the folded state, for the rotators 331, 332, 333, 334 and the hinge housing 310, at least a portion of the flow gaps g1 and g2 provided in a direction parallel to the folding axis A1 is filled with the contact structure between the first inclined portion 3312 and the second inclined portion 3122, so that even when an external impact such as a fall is applied, a phenomenon in which the two housings 210 and 220 are displaced or distorted by a shearing force can be reduced. In addition, the first inclined portion 3312 and the second inclined portion 3122 do not contact each other in a range from the unfolded state to just before the folded state (e.g., until a folding angle of about 5 ° before the completely folded state), and the flow gaps g1 and g2 are provided between the rotators 331, 332, 333 and 334 and the hinge housing 310, thereby facilitating smooth folding and unfolding of the electronic device 210.

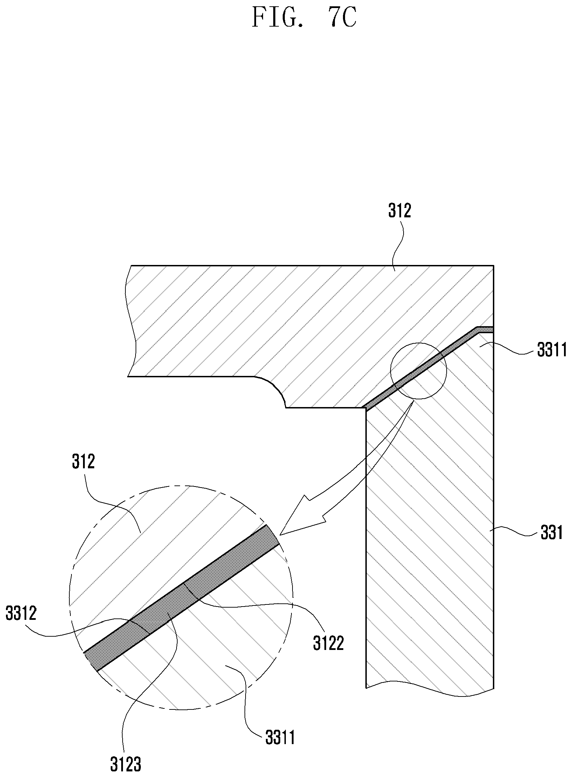

FIG. 7C is a cross-sectional view schematically showing a coupling structure between the hinge housing and the rotator according to various embodiments of the disclosure.

With reference to FIG. 7C, when the electronic device 200 is being transitioned to the folded state, noise or unwanted frictional force may be generated by a pressing force of the at least one hinge module 320 in the first inclined portion 3312 of the first rotator 331 and the second inclined portion 3122 of the first closed end 312. According to exemplary embodiments of the disclosure, the electronic device 200 may include a buffer layer 3123 disposed between the first inclined portion 3312 and the second inclined portion 3122. According to an embodiment, the buffer layer 3123 may be formed on the first inclined portion 3312 and/or the second inclined portion 3122. According to an embodiment, the buffer layer 3123 may include an elastic coating layer or a polytetrafluoroethylene (PTFE) coating layer based on an elastic material (e.g., urethane, rubber, resin, or silicone) disposed on the first inclined portion 3312 and/or the second inclined portion 3122. Although not shown, the buffer layer 3123 may also be applied in a substantially same manner to the second rotator 332 and the first closed end 312, the third rotator 333 and the second closed end 313, and/or the fourth rotator 334 and the second closed end 313.

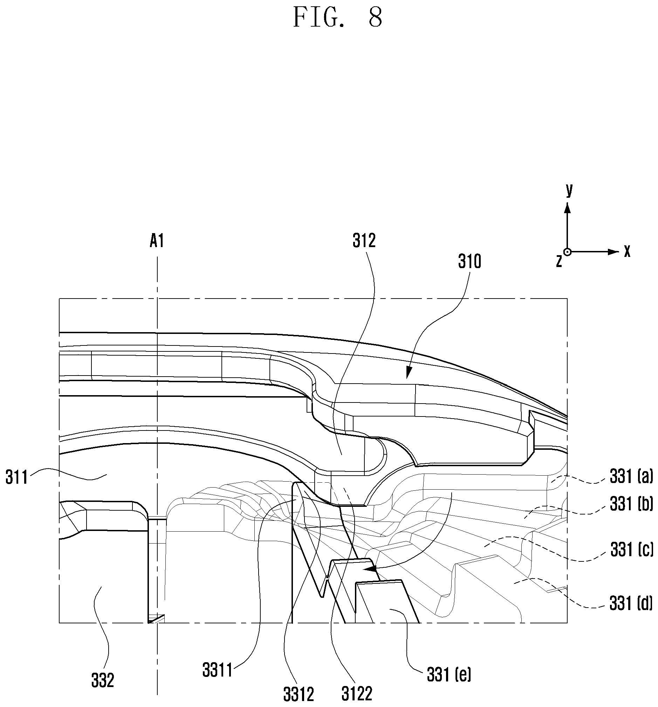

FIG. 8 is a view showing an operational trajectory of the rotator with respect to the hinge housing during a transition from the unfolded state to the folded state according to various embodiments of the disclosure.

With reference to FIG. 8, while the electronic device 200 is transitioned from the folded state to the unfolded state, the first rotator 331 may be moved, relative to the hinge housing, from position (a) being in the unfolded state, along a trajectory of (b), (c) and (d), and finally to position (e) being in the folded state. In this case, the first rotator 331 may be not in contact with the hinge housing 310 in a direction substantially parallel to the folding axis A1 (e.g., in y-axis direction) during states (a) to (d). For example, the protrusion 3311 and the first inclined portion 3312 of the first rotator 331 may not come into contact with the first closed end 312 of the hinge housing 310 during states (a) to (d). According to an embodiment, when the electronic device 200 reaches the folded state (e.g., state (e)), the first inclined portion 3312 of the first rotator 331 may come into contact with the second inclined portion 3122 of the hinge housing 310. As a result, when the electronic device 200 is placed in the folded state for carrying (relatively high possibility of a fall), the flow gap (e.g., flow gaps g1 and g2 in FIG. 6A) formed between the hinge housing 310 and the first rotator 331 in a direction of the folding axis A1 is filled with the surface contact between the first inclined portion 3312 and the second inclined portion 3122, so that a phenomenon of distortion or misalignment of the two housings 210 and 220 due to a fall may be reduced. Although not shown, when in the folded state, the second rotator 332 and the first closed end 312, the third rotator 333 and the second closed end 313, and/or the fourth rotator 334 and the second closed end 313 may also have substantially the same contact structure.

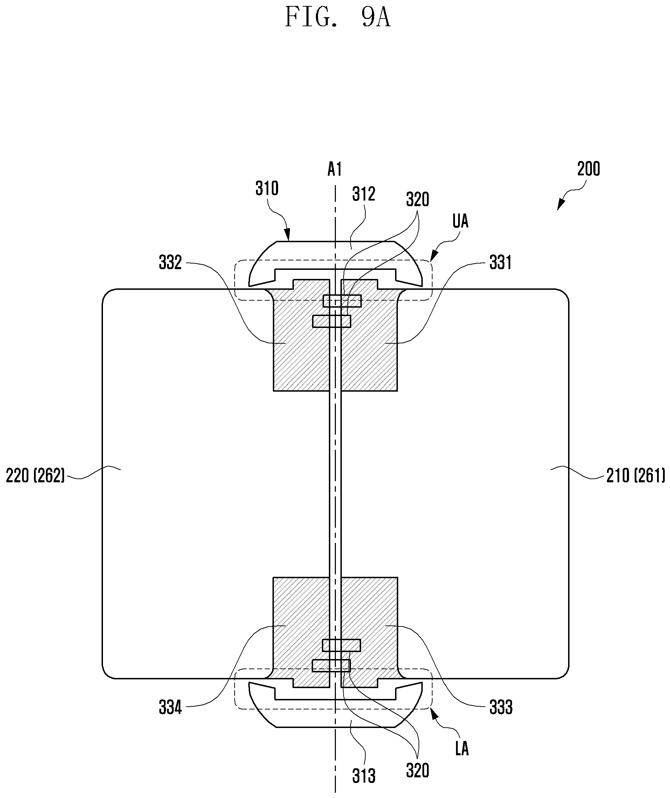

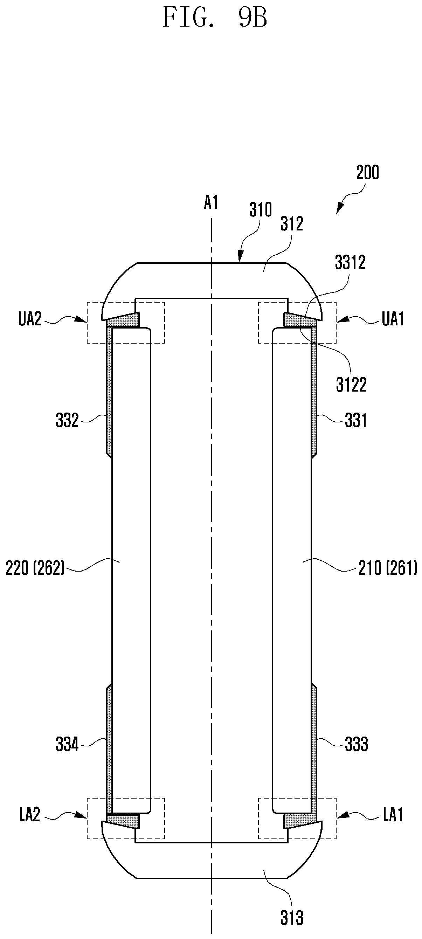

FIG. 9A and FIG. 9B are schematic views illustrating the arrangement structure of the hinge housing and the rotator, respectively, in the unfolded state and the folded state of the electronic device according to various embodiments of the disclosure.

With reference to FIGS. 9A and 9B, the electronic device 200 may include a first housing 210, a second housing 220, and a hinge device 300 that connects the first housing 210 and the second housing 220 to be foldable with respect to each other. According to an embodiment, the hinge device 300 may include a hinge housing 310 having a length in a direction substantially parallel to the folding axis A1, and a hinge module 320 fixed to the hinge housing 310 and including rotators 331, 332, 333, 334 coupled to the first housing 210 and the second housing 220. According to an embodiment, the rotators 331, 332, 333, 334 may include a first rotator 331 and a second rotator 332 disposed near the first closed end 312 formed in an upper region UA of the hinge housing 310 and coupled respectively to the first housing 210 and the second housing 220, and may include a third rotator 333 and a fourth rotator 334 disposed near the second closed end 313 formed in a lower region LA and coupled respectively to the first housing 210 and the second housing 220. According to an embodiment, the first rotator 331 and the third rotator 333 may be coupled to the first support member 261 included in the first housing 210, and the second rotator 332 and the fourth rotator 334 may be coupled to the second support member 262 included in the second housing 220.

According to various embodiments, for the first rotator 331, from the unfolded state to just before the folded state of the electronic device 200, in the upper region UA, the first inclined portion 3312 may not come into contact in a direction parallel to the folding axis A1 with the second inclined portion 3122 formed at the first closed end 312 of the hinge housing 310. Similarly, in the upper region UA, the second rotator 332 may also not come into contact with the first closed end 312 of the hinge housing 310. Likewise, in the lower region LA, the third rotator 333 may also not come into contact with the second closed end 313 of the hinge housing 310. Similarly, in the lower region UA, the fourth rotator 334 may also not come into contact with the second closed end 313 of the hinge housing 310.

According to various embodiments, for the first rotator 331, when the electronic device 200 reaches the folded state, the first inclined portion 3312 may come into contact with, in a first upper region UA1, the second inclined portion 3122 formed at the first closed end 312 of the hinge housing 310. Similarly, the second rotator 332 may come into contact with, in a second upper region UA2, at least a portion of the first closed end 312 in substantially the same manner. Similarly, the third rotator 333 may come into contact with, in a first lower region LA1, at least a portion of the second closed end 313 in substantially the same manner. Similarly, the fourth rotator 334 may come into contact with, in a second lower region LA2, at least a portion of the second closed end 313 in substantially the same manner. As a result, when the electronic device 200 is transitioned to the folded state, the flow gaps (e.g., flow gaps g1 and g2 in FIG. 6A) formed in the direction of the folding axis A1 between the hinge housing 310 and the rotators 331, 332, 333, 334 are filled with the surface contact between the inclined portions (e.g., first inclined portion 3312 and second inclined portion 3122), so that a phenomenon in which the two housings 210 and 220 are distorted or displaced due to an external impact such as a drop can be reduced.

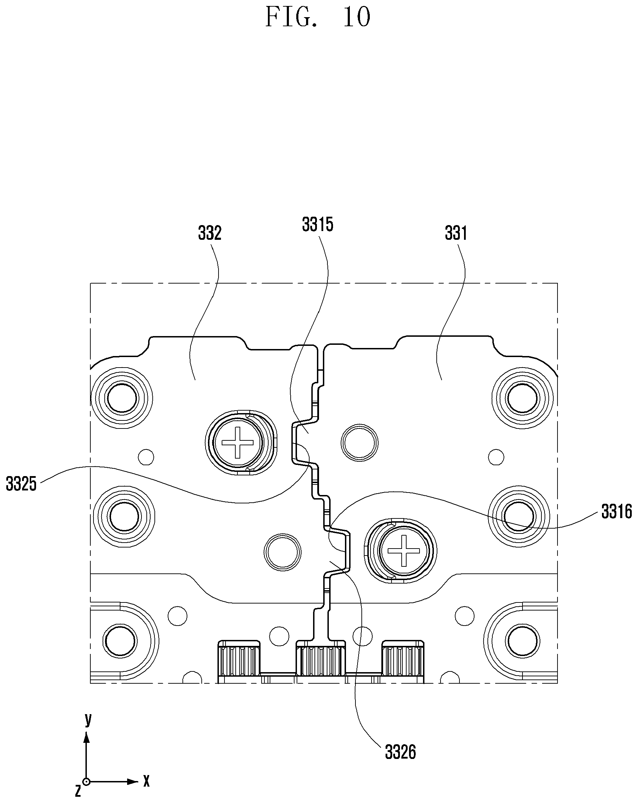

FIG. 10 is an enlarged view of a portion indicated by indicia 10 in FIG. 5 according to various embodiments of the disclosure.

The electronic device 200 according to exemplary embodiments of the disclosure may include an additional breakage prevention structure for reducing the possibility of misalignment or distortion of the two housings 210 and 220 that may be caused by an external impact such as a fall in the unfolded state.

With reference to FIG. 10, the first rotator 331 may include a first coupling protrusion 3315 that is formed, in the unfolded state of the electronic device 200, to protrude in the direction of the second rotator 332 (e.g., negative x-axis direction) and to be fitted to a first accommodation groove 3325 formed in the second rotator 332. According to an embodiment, the second rotator 332 may include a second coupling protrusion 3326 that is formed, in the unfolded state of the electronic device 200, to protrude in the direction of the first rotator 331 (e.g., x-axis direction) and to be fitted to a second accommodation groove 3316 formed in the first rotator 331. According to an embodiment, the first and second coupling protrusions 3315 and 3326 and the first and second accommodation grooves 3325 and 3316 may be coupled only when the electronic device 200 is in the unfolded state, and may be separated so as not to interfere with each other during a transition from the unfolded state to the folded state. Therefore, when the electronic device 200 is in the unfolded state, the first coupling protrusion 3315 is coupled to the first accommodation groove 3325 and the second coupling protrusion 3326 is coupled to the second accommodation groove 3316, so that a phenomenon in which the two housings 210 and 220 are distorted or displaced in a direction parallel to the folding axis A1 due to an external impact such as a drop can be reduced.

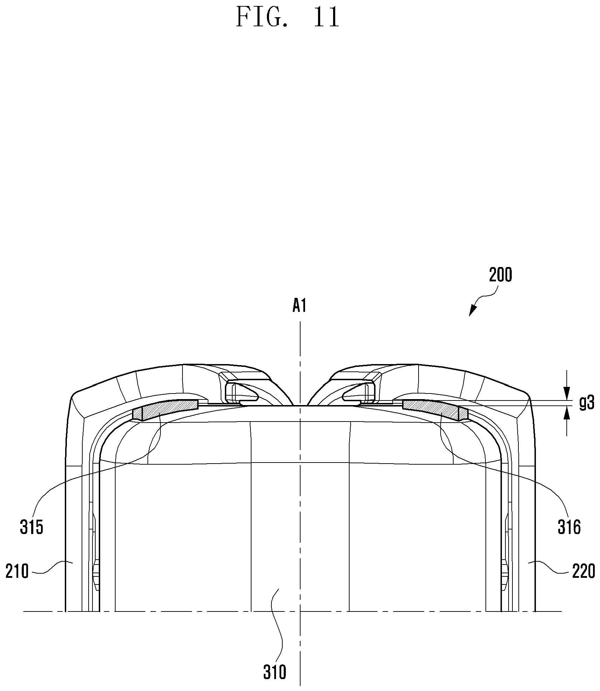

FIG. 11 is a partial perspective view of the electronic device including a breakage prevention structure disposed between the hinge housing and the two housings at a portion indicated by indicia 11 in FIG. 4B according to various embodiments of the disclosure.

With reference to FIG. 11, the electronic device 200 may include an additional prevention structure for filling a flow gap g3 formed between the hinge housing 310, the first housing 210 and the second housing 220 in the folded state. According to an embodiment, the electronic device 200 may include a first contact protrusion 315 disposed to fill the flow gap g3 between the first housing 210 and the hinge housing 310 in the folded state. According to an embodiment, the first contact protrusion 315 may be formed at a corresponding position of the first housing 210 or at a corresponding position on the outer surface of the hinge housing 310. In a certain embodiment, the first contact protrusion 315 may be replaced with the surface contact structure between the first inclined portion (e.g., first inclined portion 3312 in FIG. 6A) and the second inclined portion (e.g., second inclined portion 3122 in FIG. 6A) described above. According to an embodiment, the electronic device 200 may include a second contact protrusion 315 having substantially the same structure as the first contact protrusion 315 to fill the flow gap g3 between the second housing 220 and the hinge housing 310. According to an embodiment, the first housing 210 and the second housing 220 may be spaced apart from the hinge housing 310 through the flow gap g3 in a range from the unfolded state to just before the folded state, and may come into contact with the hinge housing 310 in a direction substantially parallel to the folding axis A1, in the folded state, as the flow gap is filled through the first contact protrusion 315 and the second contact protrusion 316. Although not shown, in a lower region of the electronic device 200, substantially the same contact protrusions may be disposed between the hinge housing 310 and the first housing 210 and between the hinge housing 310 and the second housing 220. Accordingly, in the unfolded state of the electronic device 200 according to exemplary embodiments of the disclosure, a phenomenon in which the two housings 210 and 220 are misaligned or distorted, which may be caused by an external impact such as a drop, can be reduced.

## Claims

1. An electronic device (200) comprising:
a first housing (210);
a second housing (220);
a hinge device (300) connecting the first housing and the second housing in a movable manner relative to each other with respect to a folding axis, and including:
a hinge housing (310) comprising a cover part (311) formed to have a length along the folding axis, first closed end (312) extending from one end of the cover part, and a second closed end (313) extending from the other end of the cover part, wherein an accommodation portion (3101) is formed by the cover part, the first closed end, and the second closed end;
a hinge module (320) disposed in the accommodation portion, and including a first rotator (331) coupled to the first housing and a second rotator (332) coupled to the second housing; and
a flexible display (230) disposed to be supported by the first housing, the second housing and at least a part of the hinge device,
**characterised in that**:
the first rotator (331) comprises a first protrusion (3311) which is disposed to be in contact with the first closed end in a folded state, the first protrusion being further disposed to be spaced apart from the first closed end of the hinge housing by a specified distance in a range from an unfolded state to just before the folded state , and
the second rotator (332) comprises a second protrusion which is disposed to be in contact with the first closed end in the folded state, the second protrusion being further disposed to be spaced apart from the first closed end of the hinge housing by a specified distance in the range from the unfolded state to just before the folded state.

2. The electronic device (200) of claim 1, wherein in the folded state, the first and second rotators (331, 332) and the hinge housing (310) are at least partially in contact with each other along a direction parallel to the folding axis.

3. The electronic device (200) of claim 1, wherein the first protrusion (3311) and the second protrusion have each a first inclined portion (3312), and
wherein the first closed end (312) includes second inclined portions (3122) that are formed at corresponding positions so as to come into contact with the first inclined portions (3312) of the first protrusion and the second protrusion when the electronic device is in the folded state.

4. The electronic device (200) of claim 3, wherein the first inclined portions (3312) are formed to be gradually heightened in a direction perpendicular to the folding axis in the unfolded state, and
wherein the second inclined portions (3122) are formed in a shape corresponding to the respective first inclined portions to be in contact with the first inclined portions in the folded state.

5. The electronic device (200) of claim 4, wherein the hinge module (320) includes a first hinge module which is fixed near the first closed end (312) in the accommodation portion, and a second hinge module which is spaced apart from the first closed end by a specified distance in the accommodation portion and is fixed near the second closed end (313).

6. The electronic device (200) of claim 5, wherein the second hinge module includes:
a third rotator (333) coupled to the first housing (210); and
a fourth rotator (334) coupled to the second housing (220).

7. The electronic device (200) of claim 6, wherein the first housing (210) includes a first lateral member (213) and a first support member (261) coupled to the first lateral member,
and
wherein the first support member is coupled to the first rotator (331) and the third rotator (333).

8. The electronic device (200) of claim 7, wherein the first rotator (331) and the third rotator (333) are coupled to the first support member (261) to be located in a same plane.

9. The electronic device (200) of claim 8, wherein the second housing (220) includes a second lateral member (223) and a second support member (262) coupled to the second lateral member, and
wherein the second support member is couple to the second rotator (332) and the fourth rotator (334).

10. The electronic device (200) of claim 9, wherein the second rotator (332) and the fourth rotator (334) are coupled to the second support member (262) to be located in a same plane.

11. The electronic device (200) of claim 9, wherein the flexible display (230) is disposed to cross the hinge device (300) and to be supported by the first support member (261) and the second support member (262).

12. The electronic device (200) of claim 1, wherein the hinge housing (310) and/or the first and second rotators are made of a metallic material.

13. The electronic device (200) of claim 1, wherein in the unfolded state, the cover part (311) is configured to be hidden from an outside view by the first housing (210) and the second housing (220).

## Patentansprüche

1. Elektronische Vorrichtung (200), umfassend:
ein erstes Gehäuse (210);
ein zweites Gehäuse (220);
eine Scharniervorrichtung (300), die das erste Gehäuse und das zweite Gehäuse in Bezug auf eine Faltachse bezogen aufeinander auf bewegbare Weise verbindet und Folgendes beinhaltet:
ein Scharniergehäuse (310), das ein Abdeckteil (311), das so gebildet ist, dass es eine Länge entlang der Faltachse aufweist, ein erstes geschlossenes Ende (312), das sich von einem Ende des Abdeckteils erstreckt, und ein zweites geschlossenes Ende (313) umfasst, das sich von dem anderen Ende des Abdeckteils erstreckt, wobei ein Aufnahmeabschnitt (3101) durch das Abdeckteil, das erste geschlossene Ende und das zweite geschlossene Ende gebildet ist;
ein Scharniermodul (320), das in dem Aufnahmeabschnitt angeordnet ist und eine erste Dreheinrichtung (331), die an das erste Gehäuse gekoppelt ist, und eine zweite Dreheinrichtung (332) beinhaltet, die an das zweite Gehäuse gekoppelt ist; und
eine flexible Anzeige (230), die so angeordnet ist, dass sie von dem ersten Gehäuse, dem zweiten Gehäuse und mindestens einem Teil der Scharniervorrichtung gestützt wird, **dadurch gekennzeichnet, dass**:
die erste Dreheinrichtung (331) einen ersten Vorsprung (3311) umfasst, der so angeordnet ist, dass er in einem gefalteten Zustand mit dem ersten geschlossenen Ende in Kontakt steht, wobei der erste Vorsprung ferner so angeordnet ist, dass er in einem Bereich von einem entfalteten Zustand bis kurz vor dem gefalteten Zustand um eine vorgegebene Entfernung von dem ersten geschlossenen Ende des Scharniergehäuses beabstandet ist, und
die zweite Dreheinrichtung (332) einen zweiten Vorsprung umfasst, der so angeordnet ist, dass er in dem gefalteten Zustand mit dem ersten geschlossenen Ende in Kontakt steht, wobei der zweite Vorsprung ferner so angeordnet ist, dass er in dem Bereich von dem entfalteten Zustand bis kurz vor dem gefalteten Zustand um eine vorgegebene Entfernung von dem ersten geschlossenen Ende des Scharniergehäuses beabstandet ist.

2. Elektronische Vorrichtung (200) nach Anspruch 1, wobei die erste und zweite Dreheinrichtung (331, 332) und das Scharniergehäuse (310) in dem gefalteten Zustand entlang einer Richtung parallel zu der Faltachse mindestens teilweise in Kontakt zueinander stehen.

3. Elektronische Vorrichtung (200) nach Anspruch 1, wobei der erste Vorsprung (3311) und der zweite Vorsprung jeweils einen ersten geneigten Abschnitt (3312) aufweisen und
wobei das erste geschlossene Ende (312) zweite geneigte Abschnitte (3122) beinhaltet, die an entsprechenden Positionen gebildet sind, um mit den ersten geneigten Abschnitten (3312) des ersten Vorsprungs und des zweiten Vorsprungs in Kontakt zu treten, wenn sich die elektronische Vorrichtung in dem gefalteten Zustand befindet.

4. Elektronische Vorrichtung (200) nach Anspruch 3, wobei die ersten geneigten Abschnitte (3312) gebildet sind, um in dem entfalteten Zustand in einer Richtung senkrecht zu der Faltachse allmählich erhöht zu werden, und
wobei die zweiten geneigten Abschnitte (3122) in einer Form gebildet sind, die den jeweiligen ersten geneigten Abschnitten entspricht, um in dem gefalteten Zustand in Kontakt mit den ersten geneigten Abschnitten zu treten.

5. Elektronische Vorrichtung (200) nach Anspruch 4, wobei das Scharniermodul (320) ein erstes Scharniermodul, das nahe dem ersten geschlossenen Ende (312) in dem Aufnahmeabschnitt fixiert ist, und ein zweites Scharniermodul beinhaltet, das um eine vorgegebene Entfernung in dem Aufnahmeabschnitt von dem ersten geschlossenen Ende beabstandet ist und nahe dem zweiten geschlossenen Ende (313) fixiert ist.

6. Elektronische Vorrichtung (200) nach Anspruch 5, wobei das zweite Scharniermodul Folgendes beinhaltet:
eine dritte Dreheinrichtung (333), die an das erste Gehäuse (210) gekoppelt ist; und
eine vierte Dreheinrichtung (334), die an das zweite Gehäuse (220) gekoppelt ist.

7. Elektronische Vorrichtung (200) nach Anspruch 6, wobei das erste Gehäuse (210) ein erstes Seitenelement (213) und ein erstes Stützelement (261) beinhaltet, das an das erste Seitenelement gekoppelt ist,
wobei das erste Stützelement an die erste Dreheinrichtung (331) und die dritte Dreheinrichtung (333) gekoppelt ist.

8. Elektronische Vorrichtung (200) nach Anspruch 7, wobei die erste Dreheinrichtung (331) und die dritte Dreheinrichtung (333) an das erste Stützelement (261) gekoppelt sind, um sich auf einer gleichen Ebene zu befinden.

9. Elektronische Vorrichtung (200) nach Anspruch 8, wobei das zweite Gehäuse (220) ein zweites Seitenelement (223) und ein zweites Stützelement (262) beinhaltet, das an das zweite Seitenelement gekoppelt ist, und
wobei das zweite Stützelement an die zweite Dreheinrichtung (332) und die vierte Dreheinrichtung (334) gekoppelt ist.

10. Elektronische Vorrichtung (200) nach Anspruch 9, wobei die zweite Dreheinrichtung (332) und die vierte Dreheinrichtung (334) an das zweite Stützelement (262) gekoppelt sind, um sich auf einer gleichen Ebene zu befinden.

11. Elektronische Vorrichtung (200) nach Anspruch 9, wobei die flexible Anzeige (230) so angeordnet ist, dass sie die Scharniervorrichtung (300) schneidet und von dem ersten Stützelement (261) und dem zweiten Stützelement (262) gestützt wird.

12. Elektronische Vorrichtung (200) nach Anspruch 1, wobei das Scharniergehäuse (310) und/oder die erste und zweite Dreheinrichtung aus einem metallischen Material hergestellt sind/ist.

13. Elektronische Vorrichtung (200) nach Anspruch 1, wobei das Abdeckteil (311) in dem entfalteten Zustand dazu konfiguriert ist, durch das erste Gehäuse (210) und das zweite Gehäuse (220) vor einer Außenansicht verborgen zu sein.

## Revendications

1. Dispositif électronique (200) comprenant :
un premier boîtier (210) ;
un second boîtier (220) ;
un dispositif charnière (300) reliant le premier boîtier et le second boîtier de manière mobile l'un par rapport à l'autre par rapport à un axe de pliage, et comprenant :
un boîtier de charnière (310) comprenant une partie couvercle (311) formée pour comporter une longueur le long de l'axe de pliage, une première extrémité fermée (312) s'étendant à partir d'une extrémité de la partie couvercle, et une seconde extrémité fermée (313) s'étendant à partir de l'autre extrémité de la partie couvercle, une partie de réception (3101) étant formée par la partie couvercle, la première extrémité fermée et la seconde extrémité fermée ;
un module de charnière (320) disposé dans la partie de réception, et comprenant un premier rotateur (331) couplé au premier boîtier et un deuxième rotateur (332) couplé au second boîtier ;
et
un afficheur souple (230) disposé pour être supporté par le premier boîtier, le second boîtier et au moins une partie du dispositif charnière, **caractérisé en ce que** :
le premier rotateur (331) comprend une première saillie (3311) qui est disposée pour être en contact avec la première extrémité fermée dans un état plié, la première saillie étant en outre disposée pour être espacée de la première extrémité fermée du boîtier de charnière d'une distance spécifiée dans une plage allant d'un état déplié à un état juste avant l'état plié, et
le deuxième rotateur (332) comprend une seconde saillie qui est disposée pour être en contact avec la première extrémité fermée dans l'état plié, la seconde saillie étant en outre disposée pour être espacée de la première extrémité fermée du boîtier de charnière d'une distance spécifiée dans la plage allant de l'état déplié à un état juste avant l'état plié.

2. Dispositif électronique (200) de la revendication 1, dans l'état plié, lesdits premier et deuxième rotateurs (331, 332) et ledit boîtier de charnière (310) étant au moins partiellement en contact l'un avec l'autre le long d'une direction parallèle à l'axe de pliage.

3. Dispositif électronique (200) de la revendication 1, ladite première saillie (3311) et ladite seconde saillie comportant chacune une première partie inclinée (3312), et
ladite première extrémité fermée (312) comprenant des secondes parties inclinées (3122) qui sont formées au niveau des positions correspondantes de façon à entrer en contact avec les premières parties inclinées (3312) de la première saillie et de la seconde saillie lorsque le dispositif électronique est dans l'état plié.

4. Dispositif électronique (200) de la revendication 3, lesdites premières parties inclinées (3312) étant formées pour être progressivement élevées dans une direction perpendiculaire à l'axe de pliage dans l'état déplié, et
lesdites secondes parties inclinées (3122) étant formées dans une forme correspondant aux premières parties inclinées respectives pour être en contact avec les premières parties inclinées dans l'état plié.

5. Dispositif électronique (200) de la revendication 4, ledit module de charnière (320) comprenant un premier module de charnière qui est fixé à proximité de la première extrémité fermée (312) dans la partie de réception, et un second module de charnière qui est espacé de la première extrémité fermée d'une distance spécifiée dans la partie de réception et est fixé à proximité de la seconde extrémité fermée (313).

6. Dispositif électronique (200) de la revendication 5, ledit second module de charnière comprenant : un troisième rotateur (333) couplé au premier boîtier (210) ; et
un quatrième rotateur (334) couplé au second boîtier (220).

7. Dispositif électronique (200) de la revendication 6, ledit premier boîtier (210) comprenant un premier élément latéral (213) et un premier élément de support (261) couplé au premier élément latéral, et
ledit premier élément de support étant couplé au premier rotateur (331) et au troisième rotateur (333).

8. Dispositif électronique (200) de la revendication 7, ledit premier rotateur (331) et ledit troisième rotateur (333) étant couplés au premier élément de support (261) pour être situés dans un même plan.

9. Dispositif électronique (200) de la revendication 8, ledit second boîtier (220) comprenant un second élément latéral (223) et un second élément de support (262) couplé au second élément latéral, et
ledit second élément de support étant couplé au deuxième rotateur (332) et au quatrième rotateur (334).

10. Dispositif électronique (200) de la revendication 9, ledit deuxième rotateur (332) et ledit quatrième rotateur (334) étant couplés au second élément de support (262) pour être situés dans un même plan.

11. Dispositif électronique (200) de la revendication 9, ledit afficheur souple (230) étant disposé pour croiser le dispositif de charnière (300) et pour être supporté par le premier élément de support (261) et le second élément de support (262).

12. Dispositif électronique (200) de la revendication 1, ledit boîtier de charnière (310) et/ou lesdits premier et deuxième rotateurs étant constitués d'un matériau métallique.

13. Dispositif électronique (200) de la revendication 1, dans l'état déplié, ladite partie de couvercle (311) étant conçue pour être cachée d'une vue extérieure par le premier boîtier (210) et le second boîtier (220).
